# EUROPÄISCHE PATENTSCHRIFT

(11) **EP 2 506 020 B1**
(45) Veröffentlichungstag und Bekanntmachung des Hinweises auf die Patenterteilung: **01.06.2022**
(21) Anmeldenummer: 11190717.6
(22) Anmeldetag: 25.11.2011
(51) Int. Cl.: G01R 31/12, G01R 15/18

(54) **Vorrichtung zur Messung von Strömen in Stromversorgungsnetzen**
Device for measuring currents in electricity supply networks
Dispositif de mesure de courants dans des réseaux d'alimentation

(30) Priorität: 01.04.2011 DE 102011006666
(43) Veröffentlichungstag der Anmeldung: 03.10.2012
(73) Patentinhaber: Bender GmbH & Co. KG, 35305 Grünberg (DE)
(72) Erfinder: Möll, Winfried, 35321 Laubach (DE); Schäfer, Oliver, 35305 Grünberg (DE)
(74) Vertreter: advotec.

(56) Entgegenhaltungen:
- EP-A2- 0 689 057
- DE-A1-102005 054 544
- KR-A- 20090 028 786
- NL-A- 8 303 245
- US-A1- 2010 308 800
- None

## Beschreibung

Die Erfindung betrifft eine Vorrichtung zur Messung von Strömen in Stromversorgungsnetzen, mit Messstromwandlern und mit einer auf einer Leiterplatte angeordneten Signalverarbeitungseinrichtung sowie mit Anschraubbefestigungen zur Montage der Vorrichtung.

Zur Strommessung in Leitersystemen sind Messstromwandler bekannt, bei denen der zu messende stromführende Leiter als Primärwicklung durch eine Leitungsdurchführung des Messstromwandlers hindurchgeführt wird und in der Sekundärwicklung des Messstromwandlers ein diesem Primärstrom proportionales, auswertbares Messsignal erzeugt, das einer Auswerteeinrichtung, beispielsweise einem konventionellen Strommessgerät zur Anzeige oder einer Auswerteeinrichtung zur weiteren digitalen Signalverarbeitung zugeführt wird. Derartige Messstromwandler finden Verwendung in elektrischen Schutzvorrichtungen zur Fehlerstrommessung (Differenzstrommessung) in geerdeten (TN-) Netzen, zur Prüfstrommessung in Verbindung mit Isolationsfehlersucheinrichtungen in ungeerdeten (IT-) Netzen und unabhängig von der Netzform in Vorrichtungen zur Laststrommessung.

Die Vorrichtungen zur Fehler-, Prüf- und Laststrommessung sind meist durch eine räumlich getrennte Anordnung von Messstromwandler und signalverarbeitender Auswerteeinrichtung gekennzeichnet. So sind aus dem Stand der Technik Messeinrichtungen zur Isolationsfehlersuche bekannt, bei denen die Messstromwandler als separate Einheiten getrennt von dem Gerät angeordnet sind, das die Elektronik zur Verarbeitung der von den Strommesswandlern gelieferten Messsignale trägt. Die Verbindung zwischen den einzelnen Messstromwandlern und dem signalverarbeitenden Gerät wird in der Regel über verdrillte Leitungen hergestellt. Als Nachteil bei einem Einbau in Schaltschränken erweist sich, dass derartige Anordnungen infolge der Vielzahl von getrennt montierten Messstromwandlern und ihrer Zuleitungen viel Platz benötigen, teilweise unübersichtlich und hinsichtlich der Einbaulage unflexibel sind. Das signalverarbeitende Gerät wird in einem Schaltschrank meist an einer Hutschiene befestigt, wohingegen die Wandlerelemente über Abstandshalter oder Tiefenwinkel in einer dahinter liegenden Ebene montiert sind.

Ebenfalls bekannt sind Vorrichtungen zur Isolationsfehlersuche, bei denen die Verarbeitungselektronik und die Messstromwandler in einem Gerät kombiniert sind. Eine derartige Vorrichtung ist in der Offenlegungsschrift DE 10 2005 054 544 A1 offenbart.

Diese Druckschrift beschreibt eine Einrichtung zur Ortung von Isolationsfehlern in ungeerdeten Wechselspannungsnetzen, bei der eine aus mehreren Stromwandlern bestehende Baugruppe einen Mikroprozessor mit Bus-Schnittstelle aufweist und diese Baugruppe über Tiefenwinkel in einer zweiten hinteren Ebene zwischen je zwei Hutschienen abgesenkt angeordnet ist. Dabei sind die Stromwandler zweireihig versetzt stehend auf einer Leiter-(Grund)Platte der Baugruppe so angeordnet, dass die Leitungsöffnungen der Stromwandler in montiertem Zustand der Baugruppe rechtwinklig zu den Hutschienen nach vorne zeigend angeordnet sind und die Leitungen vertikal durch die Öffnungen hindurch verlaufen.

Zwar entfällt bei dieser Einrichtung durch die Integration der Wandler eine umfangreiche Verdrahtung, aber die Einbaumöglichkeiten sind auch hier begrenzt, da eine zweckmäßige Montage nur mit Tiefenwinkeln in einer hinter der Hutschiene liegenden Ebene des Schaltschranks möglich ist.

Weiterhin ist aus der Offenlegungsschrift US 2010/308800 A1 eine Vorrichtung zur gleichzeitigen Messung von mehreren Wechselströmen in einem Stromversorgungssystem bekannt. In einem steifen oder halbsteifen Gehäuse, welches in einem Verteilkasten montiert werden kann, ist eine Vielzahl von Stromwandlern angeordnet, durch die die jeweiligen Kabel mit den zu messenden Strömen geführt werden.

In der Offenlegung KR 2009 0028786 A ist ein elektrischer Verteiler mit einer Strom-Messeinheit beschrieben. Die Strom-Messeinheit umfasst eine Leiterplatte mit Leitungsdurchführungen und mit mehreren Stromsensoren. Die Stromsensoren sind jeweils als Luftspule ausgebildet, die mittels Durchgangsbohrungen um die Front- und Rückseite der Leiterplatte gewickelt ist.

Der vorliegenden Erfindung liegt somit die Aufgabe zu Grunde, eine Vorrichtung zur Messung von Strömen in Stromversorgungsnetzen derart weiter zu entwickeln, dass diese eine möglichst kompakte Baueinheit bildet und in einer Vielzahl von Einbaulagen montierbar ist.

Diese Aufgabe wird in Verbindung mit dem Oberbegriff des Anspruchs 1 dadurch gelöst, dass Leitungsdurchführungen der Messstromwandler parallel zu einer Leiterplattenebene ausgerichtet sind, wobei die Leiterplatte zu den Leitungsdurchführungen der Messstromwandler fluchtende Öffnungen aufweist und die Anschraubbefestigungen als Befestigungslaschen mit Montagebohrungen ausgebildet sind, deren Abstände so bemessen sind, dass eine normgerechte Montage möglich ist und wobei die Messstromwandler mit der Leiterplatte in einem gemeinsamen Gehäuse verbaut sind, an dessen Gehäusekanten die Befestigungslaschen der Anschraubbefestigung einteilig angeformt sind.

Durch die erfindungsgemäße Anordnung der Messstromwandler in der Weise, dass deren Leitungsdurchführungen parallel zur Leiterplattenebene ausgerichtet sind, die ringkernförmigen Wandler also liegend auf der Leiterplatte angeordnet sind, kommt eine besonders kompakte und wenig Bauraum einnehmende Anordnung zu Stande. Die Leiterplatte weist dabei zu den Leitungsdurchführungen der flach auf der Leiterplatte aufliegenden Messstromwandler fluchtende Öffnungen auf, durch die die von dem jeweiligen Messstromwandler umfassten Leitungsabgänge geführt werden. Die Anschraubbefestigungen sind als Befestigungslaschen mit Montagebohrungen ausgebildet, so dass in vorteilhafterweise eine direkte Verschraubung an den Montageschienen eines Schaltschrankes ohne Verwendung einer Hutschiene möglich ist. Die Abstände der Montagebohrungen sind so bemessen, dass ein normgerechter Einbau an den Montageschienen ohne weitere Befestigungselemente oder Adapterstücke durchgeführt werden kann.

In weiterer vorteilhafter Ausgestaltung sind die Befestigungslaschen der Anschraubbefestigung parallel zur Leiterplattenebene ausgerichtet. Diese

Ausrichtung der Befestigungslaschen erlaubt eine Montage der Vorrichtung in der Weise, dass die Leiterplatte parallel zu einer Rückwand auf den Montageschienen verschraubt werden kann. Infolge der flach aufliegenden Messstromwandler nimmt die Vorrichtung in dieser Einbaulage eine geringe Bautiefe ein und erlaubt zudem den Platz sparenden Einbau zwischen zwei auf Hutschienen montierten Leistungsschalter-Blöcken in einem Schaltschrank. Die Stromleitungen werden somit horizontal durch die parallel zur Leiterplatte bzw. zur Wand verlaufenden Leitungsdurchführungen der Messstromwandler sowie durch die fluchtenden Öffnungen der Leiterplatte geführt.

Als zweckmäßig erweist sich, dass die Befestigungslaschen der Anschraubbefestigung - in kombinierter Anordnung mit vorgenannten parallel zur Leiterplattenebene ausgerichteten Befestigungslaschen oder ausschließlich - senkrecht zur Leiterplattenebene ausgerichtet sind. Mit dieser Ausrichtung der Befestigungslaschen ist eine liegende Einbaulage der Vorrichtung möglich, in der die Leiterplatte mit den flach aufliegenden Messstromwandlern eine geringe Bauhöhe aufweist. In dieser Montageposition verlaufen die umfassten Stromleitungen vertikal durch die Leitungsdurchführungen bzw. durch die fluchtenden Öffnungen.

Die Messstromwandler sind mit der Leiterplatte in einem gemeinsamen Gehäuse verbaut, an dessen Gehäusekanten die Befestigungslaschen der Anschraubbefestigung einteilig angeformt sind. Das gemeinsame Gehäuse nimmt die einzelnen Wandler und die die Signalverarbeitungseinrichtung tragende Leiterplatte auf. An das Gehäuse angeformt sind die Befestigungslaschen in paralleler und/oder senkrechter Ausrichtung zur Leiterplattenebene. Damit wird eine sehr kompakte, geschützte und zuverlässige bauliche Einheit geschaffen. Zweckmäßigerweise ist das Gehäuse als Spritzgussteil ausgeführt, in welches die Messstromwandler und die Leiterplatte vergossen sind. Neben der Kompaktheit der Vorrichtung erweist sich diese Ausführungsform auch als mechanisch besonders robust.

Weiterhin wird die der Erfindung zu Grunde liegende Aufgabe mit einer alternativen Lösung in Verbindung mit dem Oberbegriff des Anspruchs 6 dadurch gelöst, dass Leitungsdurchführungen der Messstromwandler senkrecht zur Leiterplattenebene ausgerichtet sind und die Anschraubbefestigungen als Winkelschiene mit Leitungsdurchlässen und normgemäßen Montagebohrungen ausgebildet sind, auf deren einer Seite innenliegend die Leiterplatte befestigt ist.

In dieser Lösungsvariante sind die Messstromwandler stehend auf der Leiterplatte montiert - also mit ihren Leitungsdurchführungen senkrecht zur Leiterplattenebene ausgerichtet - und die Leiterplatte selbst ist innenliegend an einer ersten Seite einer Winkelschiene befestigt, wobei die, senkrecht zu ersten Seite stehende, zweite Seite der Winkelschiene zu den Leitungsdurchführungen der Messstromwandler fluchtende Durchlässe zum Einführen der Leitungen aufweist. Mit Vorteil ist die Winkelschiene an beiden Seiten in den jeweiligen Außenbereichen mit normgemäßen Montagebohrungen versehen, so dass eine Einbaulage möglich ist, in der die Leiterplatte parallel zu einer Montagewand oder senkrecht zur Wandebene an Montageschienen befestigt werden kann. Darüber hinaus ist jeweils auch die Möglichkeit eines vertikalen Einbaus entlang einer Montageschiene gegeben. Für die Ausrichtung der auf der Leiterplatte stehend angeordneten Messstromwandler und damit für die Leitungsführung der umfassten Leitungen ergibt sich damit eine Vielzahl vorteilhafter Einbaupositionen.

Ebenso wird die der Erfindung zu Grunde liegende Aufgabe mit einer weiteren alternativen Lösung in Verbindung mit dem Oberbegriff des Anspruchs 7 dadurch gelöst, dass die Leitungsdurchführungen der Messstromwandler senkrecht zur Leiterplattenebene ausgerichtet sind, wobei die Messstromwandler mit der Leiterplatte in einem gemeinsamen Gehäuse verbaut sind, welches mit normgemäßen Montagebohrungen versehene Befestigungslaschen als Anschraubbefestigungen aufweist.

Auch in dieser Lösungsalternative sind die Messstromwandler stehend auf der Leiterplatte montiert, allerdings sind die Messstromwandler mit der Leiterplatte in einem gemeinsamen schützenden rechteckförmigen Gehäuse verbaut. Die Befestigungslaschen sind in vorteilhafterweise so an dem Gehäuse angebracht, dass eine wandparallele Ausrichtung der Leitungsdurchführungen der Messstromwandler als auch eine senkrecht zur Wand ausgerichtete Einbaulage möglich ist. Auch ist bei parallel zur Wand ausgerichteten Wandlern eine hängende Position der Wandler mit darüber befindlicher Leiterplatte realisierbar.

In allen Lösungsalternativen, insbesondere aber in der gemäß Anspruch 1 beanspruchten Anordnung mit flach auf der Leiterplatte liegend angeordneten Messstromwandlern, können die Messstromwandler auf der Leiterplatte in einer Reihe angeordnet sein. Damit ergibt sich eine schmal bauende längliche Einheit, die die Anordnung mehrerer Vorrichtungen in einer Ebene übereinander erlaubt und ideal auf den normgerechten Abstand zwischen zwei Montageschienen ausgerichtet ist.

In einer anderen Ausgestaltung sind die Messwandler auf der Leiterplatte versetzt in mehreren Reihen angeordnet. Bei liegend auf der Leiterplatte angeordneten Messstromwandlern kann damit die Vorrichtung eine eher quadratische Grundform annehmen, wodurch sich zwei derartige Ausführungen bevorzugt nebeneinander anordnen lassen. Auch sind kombinierte Sonderanfertigungen mit ein- und zweireihig angeordneten Wandlern denkbar.

Von Vorteil ist weiterhin, dass die Signalverarbeitungseinrichtung eine Auswerteeinheit zur kontinuierlichen Auswertung der Messstromwandler-Signale und damit zur Erkennung mehrerer gleichzeitig auftretender Ereignisse aufweist. Somit können mit der erfindungsgemäßen Vorrichtung gleichzeitig auftretende Isolationsfehler (Ereignis in ungeerdeten Netzen) oder auch gleichzeitig auftretende Fehlerströme (Ereignis in geerdeten Netzen) erkannt werden. Unabhängig von der installierten Netzform ist als Ereignis auch die gleichzeitige Messung mehrerer Lastströme möglich.

Um eine flexible Anpassung an die jeweiligen Betriebsumgebung zu ermöglichen und in ein übergreifendes Überwachungskonzept eingebunden werden zu können, weist die Signalverarbeitungseinrichtung einen Mikroprozessor mit Kommunikations-Schnittstelle auf. Zweckmäßigerweise besitzt die Vorrichtung Drehschalter zur direkten Eingabe einer Geräteadresse und ermöglicht damit eine Integration in ein Netzwerk mit mehreren Vorrichtungen zur Strommessung. Das Netzwerk kann dabei eine Bus-Struktur aufweisen.

Jedem Messstromwandler ist eine Melde-LED zur Anzeige eines Ereignisses und zur Anzeige von Statussignalen zugeordnet. Damit ist für das Betriebspersonal sofort erkennbar, in welchem Leitungsabgang ein Strom fließt.

In einer weiteren Ausführungsform ist in die Vorrichtung ein Modul zur Lichtbogenerkennung integriert. Dies ermöglicht es, dieselben Messstromwandler zur Erfassung eines Stroms heranzuziehen, der beispielsweise beim Abreißen einer Leitung entsteht und dadurch einen Lichtbogen zu erkennen. Zur spektralen Auswertung dieses Stroms weist das Modul zusätzliche Filter auf. Auch die gemeinsame Nutzung von Versorgungsspannung, Gehäuse und Kommunikations-Schnittstelle ist von Vorteil.

Weitere vorteilhafte Ausgestaltungsmerkmale ergeben sich aus der nachfolgenden Beschreibung und den Zeichnungen, die eine erste Ausführungsform der Erfindung an Hand von Beispielen erläutern. Es zeigen:
- Fig. 1:: die Integration einer erfindungsgemäßen Vorrichtung zur Strommessung in ein Stromversorgungsnetz,
- Fig. 2a, 2b:: die erfindungsgemäße Vorrichtung in einer bevorzugten ersten Ausführungsform in Draufsicht und in perspektivischer Darstellung,
- Fig. 3:: eine Leiterplatte der erfindungsgemäßen Vorrichtung in erster Ausführungsform,
- Fig. 4a, 4b:: an Montageschienen befestigte erfindungsgemäße Vorrichtungen der ersten Ausführungsform in verschiedenen Einbaulagen,
- Fig. 5:: ein funktionales Blockschaltbild der erfindungsgemäßen Vorrichtung,
- Fig.6:: ein funktionales Blockschaltbild der erfindungsgemäßen Vorrichtung mit integrierter Einheit zur Lichtbogenerkennung.
- Fig. 7:: die bevorzugte erste Ausführungsform der erfindungsgemäßen Vorrichtung mit einer alternativen Befestigung.

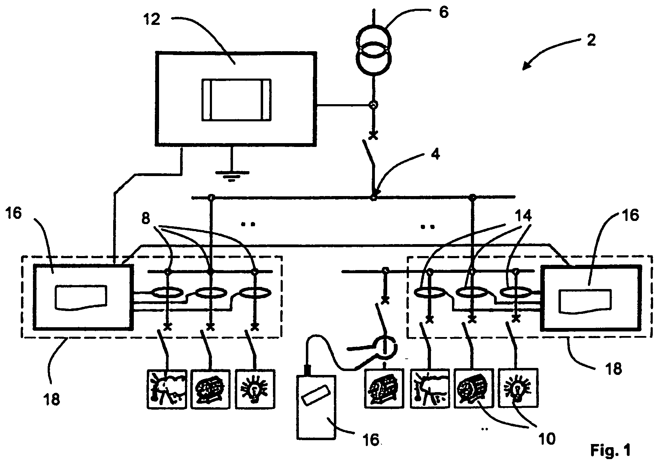

**Fig. 1** zeigt am Beispiel eines Isolationsfehlersuchsystems 2 die Integration einer erfindungsgemäßen Vorrichtung 18 zur (Prüf-)Strommessung in einem ungeerdeten Stromversorgungsnetz 4. Das Stromversorgungsnetz 4 wird von einer Stromeinspeisung 6 versorgt und weist verschiedene Leitungsabgänge 8 auf, an die Verbraucher 10 angeschlossen sind. Ein Isolationsüberwachungsgerät 12 überwacht den Isolationswiderstand des Stromversorgungsnetzes 4. Unterschreitet der Isolationswiderstand zwischen Netzleiter und Erde einen eingestellten Ansprechwert, wird die Isolationsfehlersuche automatisch oder manuell gestartet. Dazu erzeugt das Isolationsüberwachungsgerät 12 einen Prüfstrom, der über die spannungsführenden Leitungen und die Leitungsabgänge 8 zur Isolationsfehlerstelle und von dort über die Erdleitung zurück zum Isolationsüberwachungsgerät 12 fließt. Das Prüfsignal wird von allen Messstromwandlern 14 erfasst, die in diesem Prüfsignal-Stromkreis liegen. Die Messstromwandler 14 sind zur Auswertung der erfassten Signale mit einer Signalverarbeitungseinrichtung 16 verbunden, die die Zuordnung zwischen Messstromwandler 14 und Leitungsabgang 8 herstellt und somit den Fehlerort lokalisiert. Die Integration der Messstromwandler 14 und der Signalverarbeitungseinrichtung 16 in eine bauliche Einheit führt zu einer erfindungsgemäßen Vorrichtung 18. Die erfindungsgemäße Vorrichtung 18 ist ebenso dazu geeignet, die in den Leitungsabgängen 8 fließenden Lastströme zu messen oder in Verbindung mit einer Fehlerstromschutzschaltung in geerdeten Systemen 4(an Stelle des ungeerdeten Stromversorgungsnetzes 4) Differenzströme zu erfassen.

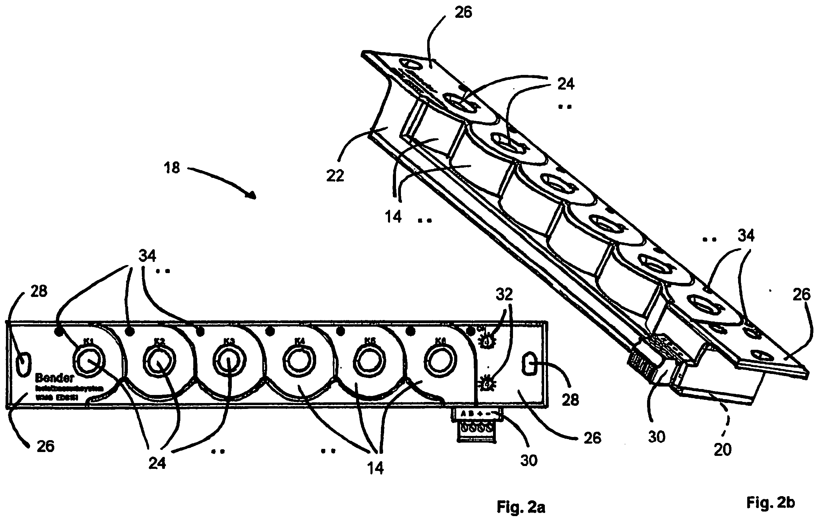

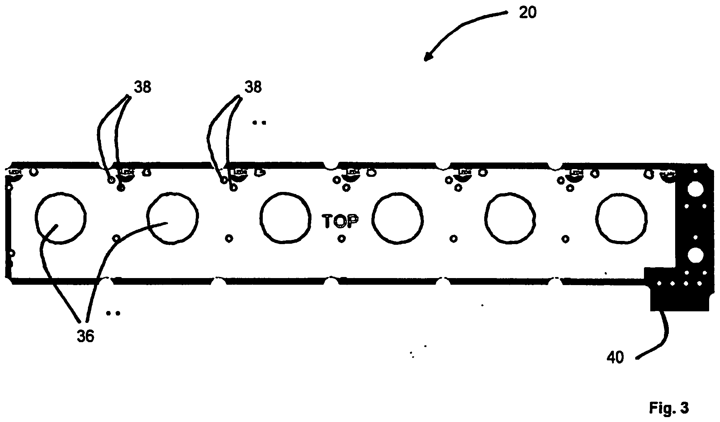

In **Fig. 2a** und **Fig. 2b** ist die erfindungsgemäße Vorrichtung 18 in der bevorzugten ersten Ausführungsform zu sehen. In dieser Ausführungsform besteht die Vorrichtung 18 aus sechs Messstromwandlern 14, die liegend in einer Reihe auf einer Leiterplatte 20 (Fig. 3) angeordnet sind, wobei Leitungsdurchführungen 24 der Messstromwandler 14 parallel zu einer Leiterplattenebene ausgerichtet sind. Die sechs Messstromwandler 14 sind mit der Leiterplatte 20 in ein gemeinsames als Spritzgussteil ausgeführtes Gehäuse 22 vergossen. An dessen schmalen Seiten sind bündig abschließend mit der Oberseite der Leitungsdurchführungen 24 Befestigungslaschen 26 als Anschraubbefestigungen angeformt, deren Montagebohrungen 28 als Langlöcher ausgeführt sind. Das Gehäuse 22 weist eine 4-polige Kommunikations-Schnittstelle 30 auf, die als Bus-Schnittstelle ausgeführt sein kann und zur Anbindung der Vorrichtung an ein Stromversorgungs-Überwachungssystem dient. Zwei Drehschalter 32 auf der Oberseite des Gehäuses 22 erlauben die stromlose Eingabe einer Geräteadresse. Zur individuellen Fehler- und Statusanzeige befindet sich an jedem Messstromwandler 14 auf der Gehäuseoberseite eine Melde-LED 34.

**Fig. 3** zeigt ein Platinen-Layout der Leiterplatte 20 der erfindungsgemäßen Vorrichtung 18 in der Ausführungsform nach den Fig. 2a und 2b. Zu erkennen sind die zu den Leitungsdurchführungen 24 der Messstromwandler 14 (Fig. 2a, 2b) fluchtenden Öffnungen 36 der Leiterplatte 20 sowie die Platinendurchführungen 38 zum Anschluss der Melde-LED-Zuleitungen. Im rechten Randbereich der Leiterplatte 20 befindet sich eine Grundleiste 40 zur Aufnahme eines Mikroprozessors und der (physikalischen) Kommunikations-Schnittstelle 30 (Fig. 2a, 2b).

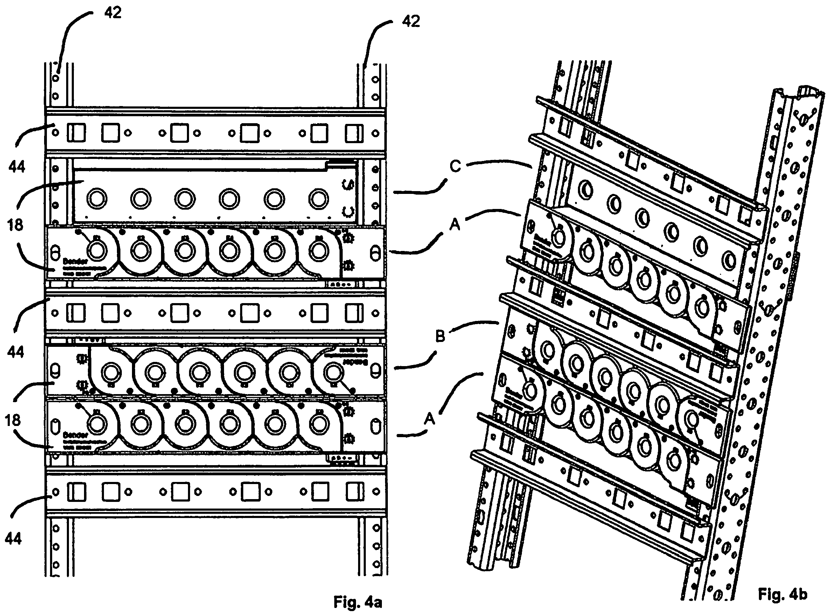

In **Fig. 4a** und **Fig. 4b** ist die Vorrichtung 18 - in normgerechten Abstand - direkt an zwei Montageschienen 42 befestigt. In einer ersten Einbaulage A ist die Vorrichtung 18 frontseitig auf die Montageschienen 42 aufgesetzt, in einer zweiten Einbaulage B ist die Vorrichtung 18 ebenfalls frontseitig, aber 180° gedreht montiert und in einer dritten Einbaulage C ist eine rückwärtige Anordnung der Vorrichtung 18 möglich. Zwischen den Vorrichtungen 18 sind in vertikaler Richtung Hutschienen 44 an den Montageschienen 42 befestigt, auf die andere elektrische Betriebsmittel montiert werden können. Auf eine Hutschiene 44 als Befestigungshalterung für die erfindungsgemäße Vorrichtung 18 kann in beiden Einbaulagen A, B verzichtet werden. Man erkennt, dass wegen der kompakten Gestaltung der Vorrichtung 18 eine äußerst Platz sparende Anordnung, auch von mehreren Vorrichtungen 18 übereinander, erreicht wird.

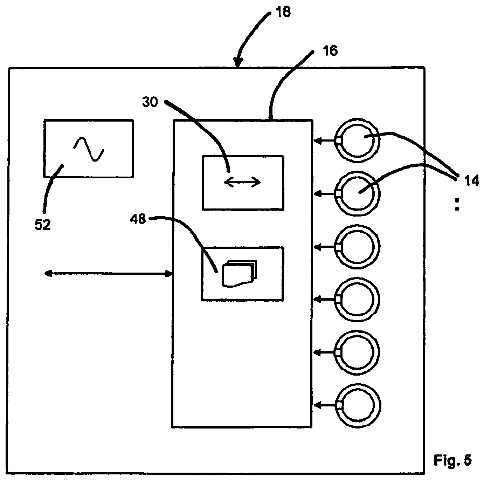

Ein funktionales Blockschaltbild der erfindungsgemäßen Vorrichtung 18 ist in **Fig. 5** zu sehen. Die Vorrichtung 18 besteht im Wesentlichen aus einer Anzahl von Messstromwandlern 14 - wobei die Anzahl der Messstromwandler 14 bei der Konstruktion der Vorrichtung 14 prinzipiell entsprechend den elektrischen und baulichen Anforderungen frei festgelegt werden kann - und der Signalverarbeitungseinrichtung 16 sowie einem Netzteil 52 zur eigenen Stromversorgung. In dem dargestellten Ausführungsbeispiel umfasst die Signalverarbeitungseinrichtung 16 die (logische) Kommunikations-Schnittstelle 30 sowie eine Auswerteeinheit 48 zur kontinuierlichen Auswertung der Messstromwandler-Signale. In ungeerdeten Systemen können damit bei einer Prüfstrommessung mehrere gleichzeitig auftretender Isolationsfehler erkannt werden, bei der Differenzstrommessung in geerdeten Systemen sind mehrere gleichzeitig auftretende Fehlerströme feststellbar. Darüber hinaus erlaubt die erfindungsgemäße Vorrichtung 18 die gleichzeitige Messung mehrerer Lastströme. Die funktionalen Blöcke 30, 48, 50 der Signalverarbeitungseinrichtung 16 können dabei als Computerprogramme auf einem Mikroprozessor implementiert sein.

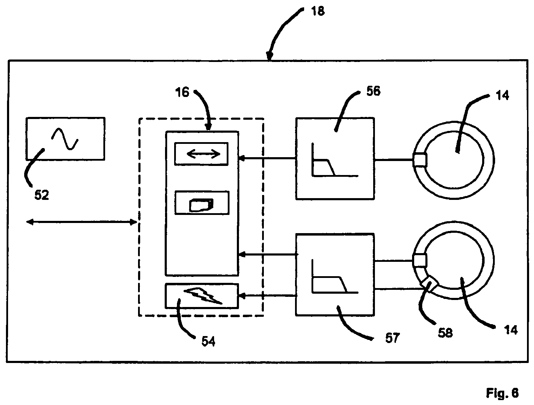

Eine weitere Ausführungsform der erfindungsgemäßen Vorrichtung 18 ist in dem funktionalen Blockschaltbild aus **Fig. 6** gezeigt. Neben der Messstromerfassung und -auswertung mit der Signalverarbeitungseinrichtung 16 über das Filter 56 ist in dieser Ausführung ein Modul zur Lichtbogenerkennung 54 integriert. Das Modul 54 nutzt ein separates Filter 57, an das eine separate Wandlerwicklung 58 angeschlossen ist, welche ein Messsignal zur Erfassung des einen Lichtbogen charakterisierenden Stroms liefert.

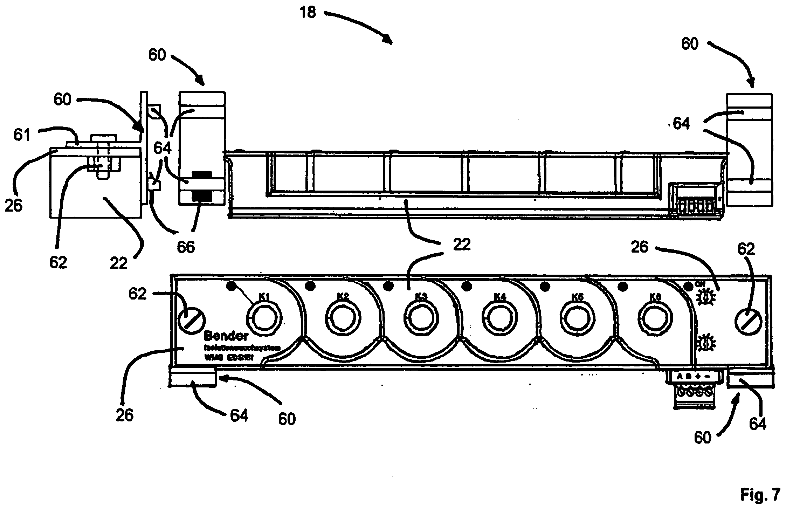

Die **Fig. 7** zeigt eine weitere Befestigungsmöglichkeit der erfindungsgemäßen Vorrichtung. Dabei sind in Verbindung mit der ersten bevorzugten Ausführungsform nach Fig. 2a, 2b Hutschienen-Clips 60 zur Verrastung mit der Hutschiene 44 an den beiden angeformten Befestigungslaschen 26 des Gehäuses 22 angebracht. Die Hutschienen-Clips 60 sind als abgewinkelte T-förmige Elemente ausgebildet, deren jeweilige Anbaulasche 61 mittels Schraubbefestigung 62 mit den Befestigungslaschen 26 derart verbunden sind, dass jeweils zwei Rastnasen 64 eines Hutschienen-Clips 60 in einer senkrecht zur Leiterplattenebene stehenden Ebene an der Hutschiene 44 verrastbar sind. Zusätzlich kann die Verbindung zur Hutschiene 44 mit einem Sicherungselement 66 gesichert sein. Auch können die Hutschienen-Clips 60 ohne Anbaulasche 61 als übliche Hutschienen-Clips 60 ausgeführt sein, die mit einer Seitenfläche auf den Befestigungslaschen 26 aufliegend mit diesen direkt über die Montagebohrungen 28 an den Befestigungslaschen 26 verschraubt sind.

## Patentansprüche

1. Vorrichtung zur Messung von Strömen in Stromversorgungsnetzen (4), mit Messstromwandlern (14) und mit einer auf einer Leiterplatte (20) angeordneten Signalverarbeitungseinrichtung (16) sowie mit Anschraubbefestigungen (26) zur Montage der Vorrichtung (18),
**dadurch gekennzeichnet,**
**dass** Leitungsdurchführungen (24) der Messstromwandler (14) parallel zu einer Leiterplattenebene ausgerichtet sind, wobei die Leiterplatte (20) zu den Leitungsdurchführungen (24) der Messstromwandler (14) fluchtende Öffnungen (36) aufweist und die Anschraubbefestigungen (26) als Befestigungslaschen (26) mit Montagebohrungen (28) ausgebildet sind, deren Abstände so bemessen sind, dass eine normgerechte Montage möglich ist und wobei die Messstromwandler (14) mit der Leiterplatte (20) in einem gemeinsamen Gehäuse (22) verbaut sind, an dessen Gehäusekanten die Befestigungslaschen (26) der Anschraubbefestigung (26) einteilig angeformt sind.

2. Vorrichtung nach Anspruch 1,
**dadurch gekennzeichnet,**
**dass** die Befestigungslaschen (26) der Anschraubbefestigung (26) parallel zur Leiterplattenebene ausgerichtet sind.

3. Vorrichtung nach Anspruch 1 oder 2,
**dadurch gekennzeichnet,**
**dass** die Befestigungslaschen der Anschraubbefestigung senkrecht zur Leiterplattenebene ausgerichtet sind.

4. Vorrichtung nach Anspruch 3,
**dadurch gekennzeichnet,**
**dass** das Gehäuse (22) als Spritzgussteil ausgeführt ist, in welches die Messstromwandler (14) und die Leiterplatte (20) vergossen sind.

5. Vorrichtung zur Messung von Strömen in Stromversorgungsnetzen (4), mit Messstromwandlern (14) und mit einer auf einer Leiterplatte (20) angeordneten Signalverarbeitungseinrichtung (16) sowie mit Anschraubbefestigungen (26) zur Montage der Vorrichtung (18),
**dadurch gekennzeichnet,**
**dass** Leitungsdurchführungen (24) der Messstromwandler (14) senkrecht zur Leiterplattenebene ausgerichtet sind und die Anschraubbefestigungen (26) als Winkelschiene mit Leitungsdurchlässen und normgemäßen Montagebohrungen (28) ausgebildet sind, auf deren einer Seite innenliegend die Leiterplatte (20) befestigt ist.

6. Vorrichtung zur Messung von Strömen in Stromversorgungsnetzen (4), mit Messstromwandlern (14) und mit einer auf einer Leiterplatte (20) angeordneten Signalverarbeitungseinrichtung (16) sowie mit Anschraubbefestigungen (26) zur Montage der Vorrichtung (18),
**dadurch gekennzeichnet,**
**dass** die Leitungsdurchführungen (24) der Messstromwandler (14) senkrecht zur Leiterplattenebene ausgerichtet sind, wobei die Messstromwandler (14) mit der Leiterplatte (20) in einem gemeinsamen Gehäuse (22) verbaut sind, welches mit normgemäßen Montagebohrungen (28) versehene Befestigungslaschen (26) als Anschraubbefestigungen (26) aufweist.

7. Vorrichtung nach einem der Ansprüche 1 bis 6,
**dadurch gekennzeichnet,**
**dass** die Messstromwandler (14) auf der Leiterplatte (20) in einer Reihe angeordnet sind.

8. Vorrichtung nach einem der Ansprüche 1 bis 7,
**dadurch gekennzeichnet,**
**dass** die Messstromwandler (14) auf der Leiterplatte (20) versetzt in mehreren Reihen angeordnet sind.

9. Vorrichtung nach einem der Ansprüche 1 bis 8,
**dadurch gekennzeichnet,**
**dass** die Signalverarbeitungseinrichtung (16) eine Auswerteeinheit (48) zur kontinuierlichen Auswertung der Messstromwandler-Signale und damit zur Erkennung mehrerer gleichzeitig auftretender Ereignisse aufweist.

10. Vorrichtung nach einem der Ansprüche 1 bis 9,
**dadurch gekennzeichnet,**
**dass** die Signalverarbeitungseinrichtung (16) einen Mikroprozessor mit Kommunikations-Schnittstelle aufweist.

11. Vorrichtung nach einem der Ansprüche 1 bis 10,
**dadurch gekennzeichnet**,
Drehschalter (32) zur Eingabe einer Geräteadresse.

12. Vorrichtung nach einem der Ansprüche 1 bis 11,
**dadurch gekennzeichnet,**
**dass** jedem Messstromwandler (14) eine Melde-LED (34) zur Anzeige eines Ereignisses und zur Anzeige von Statussignalen zugeordnet ist.

13. Vorrichtung nach einem der Ansprüche 1 bis 12,
**gekennzeichnet durch**,
die Integration eines Moduls zur Lichtbogenerkennung (54).

14. Vorrichtung nach einem der Ansprüche 1 bis 13,
**gekennzeichnet durch**,
die Befestigung mit einem an der Befestigungslasche (26) angebrachten Hutschienen-Clip (60) zur Montage auf einer Hutschiene (44).

15. Vorrichtung nach Anspruch 14,
**dadurch gekennzeichnet,**
**dass** der Hutschienen-Clip (60) als abgewinkeltes T-förmiges Element ausgebildet ist.

## Claims

1. A device for measuring currents in power supply networks (4), the device having measuring current transformers (14) and having a signal processing apparatus (16) arranged on a printed circuit board (20) and having screw fastenings (26) for mounting the device (18),
**characterised in that**
cable ducts (24) of the measuring current transformers (14) are orientated parallel to a printed circuit board plane, wherein the printed circuit board (20) has openings (36) flush to the cable ducts (24) of the measuring current transformers (14) and the screw fastenings (26) are constructed as fastening tabs (26) having mounting holes (28), the spacings of which are dimensioned in such a manner that a standards-compliant mounting is possible and wherein the measuring current transformers (14) are installed with the printed circuit board (20) in a common housing (22), on the housing edges of which the fastening tabs (26) of the screw fastening (26) are integrally moulded.

2. The device according to Claim 1,
**characterised in that**
the fastening tabs (26) of the screw fastening (26) are orientated parallel to the printed circuit board plane.

3. The device according to Claim 1 or 2,
**characterised in that**
the fastening tabs of the screw fastening are orientated perpendicularly to the printed circuit board plane.

4. The device according to Claim 3,
**characterised in that**
the housing (22) is realised as an injection moulded part into which the measuring current transformers (14) and the printed circuit board (20) are cast.

5. A device for measuring currents in power supply networks (4), the device having measuring current transformers (14) and having a signal processing apparatus (16) arranged on a printed circuit board (20) and having screw fastenings (26) for mounting the device (18),
**characterised in that**
cable ducts (24) of the measuring current transformers (14) are orientated perpendicularly to the printed circuit board plane and the screw fastenings (26) are constructed as angle rails having cable outlets and standards-compliant mounting holes (28), on the one side of which the printed circuit board (20) is internally fastened.

6. A device for measuring currents in power supply networks (4), the device having measuring current transformers (14) and having a signal processing apparatus (16) arranged on a printed circuit board (20) and having screw fastenings (26) for mounting the device (18),
**characterised in that**
the cable ducts (24) of the measuring current transformers (14) are orientated perpendicularly to the printed circuit board plane, wherein the measuring current transformers (14) are installed with the printed circuit board (20) in a common housing (22) which has fastening tabs (26) provided with standards-compliant mounting holes (28) as screw fastenings (26).

7. The device according to one of Claims 1 to 6,
**characterised in that**
the measuring current transformers (14) are arranged in a row on a printed circuit board (20).

8. The device according to one of Claims 1 to 7,
**characterised in that**
the measuring current transformers (14) are arranged offset in a plurality of rows on the printed circuit board (20).

9. The device according to one of Claims 1 to 8,
**characterised in that**
the signal processing apparatus (16) has an analysing unit (48) for the continuous analysis of the measuring current transformer signals and therefore for the detection of a plurality of simultaneously occurring incidences.

10. The device according to one of Claims 1 to 9,
**characterised in that**
the signal processing apparatus (16) has a microprocessor having a communication interface.

11. The device according to one of Claims 1 to 10,
**characterised by**
a rotary switch (32) for the input of a device address.

12. The device according to one of Claims 1 to 11,
**characterised in that**
an LED indicator (34) for indicating an incident and for indicating status signals is assigned to each measuring current transformer (14).

13. The device according to one of Claims 1 to 12,
**characterised by**
the integration of a module for arc detection (54).

14. The device according to one of Claims 1 to 13,
**characterised by**
the fastening with a top-hat-rail clip (60) attached on the fastening tab (26) for mounting on a top-hat rail (44).

15. The device according to Claim 14,
**characterised in that**
the top-hat-rail clip (60) is constructed as an angled T-shaped element.

## Revendications

1. Dispositif pour la mesure de courants dans des réseaux électriques (4), le dispositif ayant des transformateurs (14) de courant de mesure et ayant un moyen (16) de traitement de signaux disposé sur une carte imprimée (20) et ayant des fixations de vis (26) pour le montage du dispositif (18),
**caractérisé en ce que**
des conduits de câbles (24) des transformateurs (14) de courant de mesure sont orientés parallèlement à un plan de la carte imprimée (20), la carte imprimée (20) ayant des ouvertures (36) alignées aux conduits de câbles (24) du transformateurs (14) de courant de mesure et les fixations de vis (26) étant réalisées comme pattes de fixation (26) ayant des trous de montage (28) dont les distances sont dimensionnés de telle manière qu'un montage adapté aux normes est possible, et les transformateurs (14) de courant de mesure étant installés avec la carte imprimée (20) dans un boîtier (22) commun, les pattes (26) de la fixation de vis (26) étant moulées d'un seul tenant sur les bords du boîtier.

2. Dispositif selon la revendication 1,
**caractérisé en ce que**
les pattes (26) de la fixation de vis (26) sont orientées parallèlement au plan de la carte imprimée (20).

3. Dispositif selon la revendication 1 ou la revendication 2,
**caractérisé en ce que**
les pattes de la fixation de vis sont orientées perpendiculairement au plan de la carte imprimée (20).

4. Dispositif selon la revendication 3,
**caractérisé en ce que**
le boîtier (22) est réalisé comme pièce moulée par injection dans lequel sont coulés les transformateurs (14) de courant de mesure et la carte imprimée (20).

5. Dispositif pour la mesure de courants dans des réseaux électriques (4), le dispositif ayant des transformateurs (14) de courant de mesure et ayant un moyen (16) de traitement de signaux disposé sur une carte imprimée (20) et ayant des fixations de vis (26) pour le montage du dispositif (18),
**caractérisé en ce que**
des conduits de câbles (24) des transformateurs (14) de courant de mesure sont orientés perpendiculairement à un plan de la carte imprimée (20) et les fixations de vis (26) sont réalisées comme cornières ayant des sorties de câbles et des trous de montage (28) adaptés aux normes, la carte imprimée (20) étant fixée à l'intérieur sur l'un de ses côtés.

6. Dispositif pour la mesure de courants dans des réseaux électriques (4), le dispositif ayant des transformateurs (14) de courant de mesure et ayant un moyen (16) de traitement de signaux disposé sur une carte imprimée (20) et ayant des fixations de vis (26) pour le montage du dispositif (18),
**caractérisé en ce que**
les conduits de câbles (24) des transformateurs (14) de courant de mesure sont orientés perpendiculairement au plan de la carte imprimée (20), les transformateurs (14) de courant de mesure étant installés avec la carte imprimée (20) dans un boîtier (22) commun qui a des pattes de fixation (26) pourvues de trous de montage (28) adaptés aux normes comme fixations de vis (26).

7. Dispositif selon l'une quelconque des revendications 1 à 6,
**caractérisé en ce que**
les transformateurs (14) de courant de mesure sont disposés en ligne sur la carte imprimée (20).

8. Dispositif selon l'une quelconque des revendications 1 à 7,
**caractérisé en ce que**
les transformateurs (14) de courant de mesure sont disposés de manière décalée en une pluralité de lignes sur la carte imprimée (20).

9. Dispositif selon l'une quelconque des revendications 1 à 8,
**caractérisé en ce que**
le moyen (16) de traitement de signaux a une unité d'analyse (48) pour l'analyse continue des signaux du transformateur de courant de mesure et, ainsi, pour la détection de plusieurs évènements se produisant simultanément.

10. Dispositif selon l'une quelconque des revendications 1 à 9,
**caractérisé en ce que**
le moyen (16) de traitement de signaux a un microprocesseur ayant une interface de communication.

11. Dispositif selon l'une quelconque des revendications 1 à 10,
**caractérisé par**
un commutateur rotatif (32) pour la saisie de l'adresse de dispositif.

12. Dispositif selon l'une quelconque des revendications 1 à 11,
**caractérisé en ce**
**qu'**un voyant DEL (34) pour l'indication d'un évènement et pour l'indication de signaux d'état est assigné à chaque transformateur (14) de courant de mesure.

13. Dispositif selon l'une quelconque des revendications 1 à 12,
**caractérisé par**
l'intégration d'un module pour la détection (54) d'arcs électriques.

14. Dispositif selon l'une quelconque des revendications 1 à 13,
**caractérisé par**
la fixation avec un clip de profilé chapeau (60) fixé sur la patte de fixation (26) et destiné pour le montage sur un profilé chapeau (44).

15. Dispositif selon la revendication 14,
**caractérisé en ce que**
le clip de profilé chapeau (60) est réalisé comme élément plié et en forme de T.
